# EUROPEAN PATENT APPLICATION

(11) **EP 1 950 322 A1**
(43) Date of publication of application: **30.07.2008**
(21) Application number: 07108157.4
(22) Date of filing: 14.05.2007
(51) Int. Cl.: C23C 14/34, C22C 1/04

(54) **Full density Co-W magnetic sputter targets**

(30) Priority: 11.01.2007 US 653003
(71) Applicant: Heraeus, Inc., Chandler AZ 85226 (US)
(72) Inventor: Yang, Fenglin, Gilbert, AZ 85296 (US); Kunkel, Bernd, Phoenix, AZ 85048 (US); Kennedy, Steven Roger, Chandler, AZ 85226 (US); Das, Anirban, Chandler, AZ 85225 (US)
(74) Representative: Hill, Justin John

(57) **Abstract**

A sputter target is provided with a first elemental phase of a first material, the first material being either cobalt or tungsten, a first intermetallic phase including the first material and a second material, the second material being either tungsten or cobalt and different from the first material, the first material in a greater atomic percentage than the second material, and a second intermetallic phase including the second material and the first material, the second material in a greater atomic percentage than the first material. The sputter target includes 20-80 at.% cobalt, and has a density greater than 99% of a theoretical maximum density thereof. The sputter target is fabricated by selecting a cobalt powder and a tungsten powder having the same particle size distribution, blending the cobalt powder and the tungsten powder to form a blended powder, canning the blended powder, hot pressing the blended powder to form a solid, and machining the solid to form a sputter target.

## Description

### CROSS-REFERENCE TO RELATED APPLICATION

Not applicable.

### STATEMENT REGARDING FEDERALLY SPONSORED RESEARCH OR DEVELOPMENT

Not applicable.

### FIELD OF THE INVENTION

The present invention generally relates to sputter targets and, in particular, relates to full density cobalt-tungsten sputter targets and methods for manufacturing the same.

### BACKGROUND OF THE INVENTION

The manufacture of full density cobalt-tungsten sputtering targets presents a number of challenges. Specifically, because of the difference in density between cobalt (Co) and tungsten (W), the elemental phases in a sputter target containing both tend to segregate during manufacture. Moreover, the formation of excessive intermetallic phases during manufacture can render the resultant alloy extremely hard, brittle, and prone to cracking during processing.

### SUMMARY OF THE INVENTION

The present invention solves the foregoing problems by providing fully dense cobalt-tungsten sputter targets and methods of manufacturing the same. The targets may contain between 20-80 at.% cobalt and 80-20 at.% tungsten. The targets have a substantially uniform multi-phase microstructure, and are substantially chemically homogenous both across their surface and through their thickness (*i.e.,* along the sputter direction). The optimized volume fractions of the intermetallic phases and the elemental phase(s) allow the targets to maintain mechanical strength (*e.g.*, resistance to cracking during hot isostatic pressing, machining, or subsequent sputtering) and machinability while achieving a density greater than about 99% of a theoretical maximum density. The micro-cracks and micro-porosities that plague other cobalt-tungsten targets have been minimized.

According to one embodiment of the present invention, a method of fabricating a sputter target comprises the steps of selecting a cobalt powder having a particle size distribution and a tungsten powder having the same particle size distribution, blending the cobalt powder and the tungsten powder to form a blended powder, canning the blended powder, hot pressing the blended powder to form a solid, and machining the solid to form a sputter target.

According to another embodiment of the present invention, a sputter target comprises a first elemental phase of a first material, the first material being either cobalt or tungsten, a first intermetallic phase including the first material and a second material, the second material being either tungsten or cobalt and different from the first material, the first material in a greater atomic percentage than the second material, and a second intermetallic phase including the second material and the first material, the second material in a greater atomic percentage than the first material. The sputter target includes 20-80 at.% cobalt, and a density of the sputter target is greater than 99% of a theoretical maximum density thereof.

It is to be understood that both the foregoing summary of the invention and the following detailed description are exemplary and explanatory and are intended to provide further explanation of the invention as claimed.

### BRIEF DESCRIPTION OF THE DRAWINGS

The accompanying drawings, which are included to provide further understanding of the invention and are incorporated in and constitute a part of this specification, illustrate embodiments of the invention and together with the description serve to explain the principles of the invention. In the drawings:

Figures 1A and 1B illustrate the microstructure of a cross section of a cobalt-tungsten sputter target exhibiting segregation of the cobalt and tungsten elemental phases;

Figures 2A and 2B illustrate the microstructure of a cross section of a cobalt-tungsten sputter target exhibiting Kirkendall porosities;

Figure 3A illustrates the microstructure of a cross section of a cobalt-tungsten sputter target exhibiting excessive micro-cracks in the intermetallic phases thereof;

Figure 3B illustrates the microstructure of a cross section of a cobalt-tungsten sputter target exhibiting voids in an incompletely sintered tungsten phase thereof;

Figure 4 illustrates the microstructure of a cross section of a 60Co-40W sputter target according to one embodiment of the present invention;

Figures 5A and 5B illustrate the microstructure of a cross section of a 60Co-40W sputter target according to one embodiment of the present invention;

Figure 6 illustrates the microstructure of a cross section of a 40Co-60W sputter target according to one embodiment of the present invention;

Figure 7 is a flow chart illustrating a method of manufacturing a sputter target according to one embodiment of the present invention.

### DETAILED DESCRIPTION OF THE INVENTION

In the following detailed description, numerous specific details are set forth to provide a full understanding of the present invention. It will be apparent, however, to one ordinarily skilled in the art that the present invention may be practiced without some of these specific details in other instances, well-known structures and techniques have not been shown in detail to avoid unnecessarily obscuring the present invention.

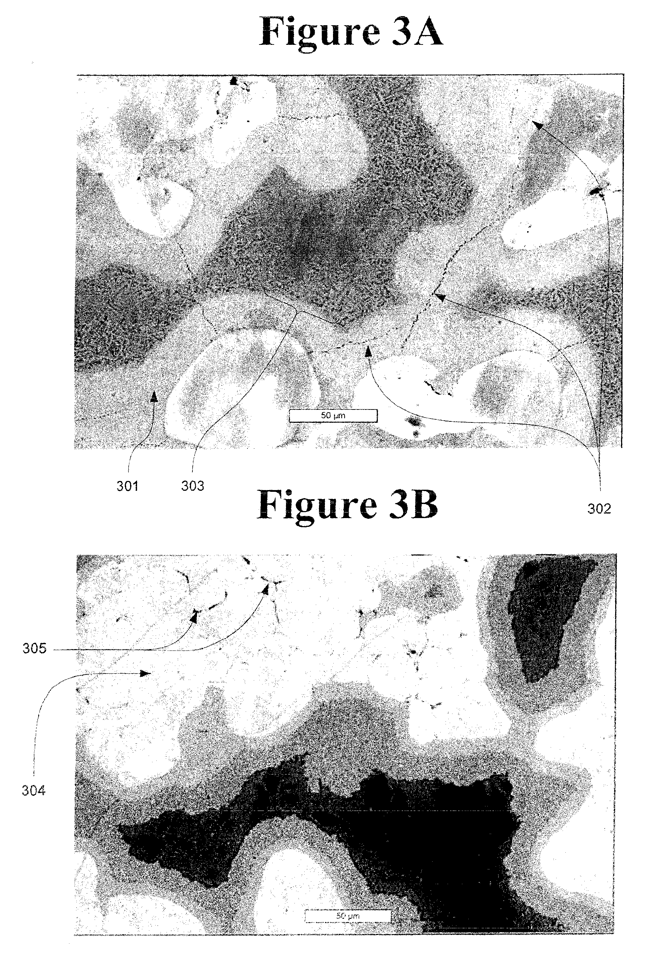

One approach to fabricating fully dense cobalt-tungsten sputter targets involves increasing the hot isostatic press ("HIP") temperature and hold time in order to reduce the occurrence of voids in tungsten-rich regions. One drawback to this approach, however. Is the excessive formation of intermetallic phases, rendering the alloy too brittle and hard to machine without cracking. Another drawback to increasing the time and temperature of the HIP is the formation of Kirkendall porosities. Reducing the temperature and time of the HIP to avoid these issues, however, prevents the tungsten-rich areas of the target from consolidating, leaving voids in those regions that reduce the final density of the target, as shown in Figure 3B. These voids, together with connected micro-porosities and undesirably large micro-cracks which may also form, may allow liquid or moisture to be soaked into the target body, permitting Co/W oxides or hydroxides to form. These oxides and hydroxides cause corrosion in the target and accordingly reduce its sputtering performance.
Accordingly, these approaches are unable to produce a fully dense cobalt-tungsten sputter target free from oxidization, corrosion, cracking, and phase segregation.

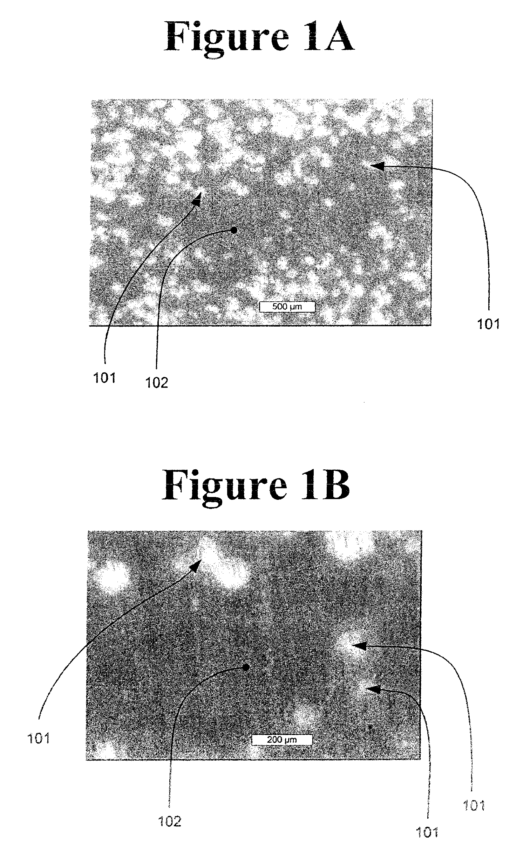

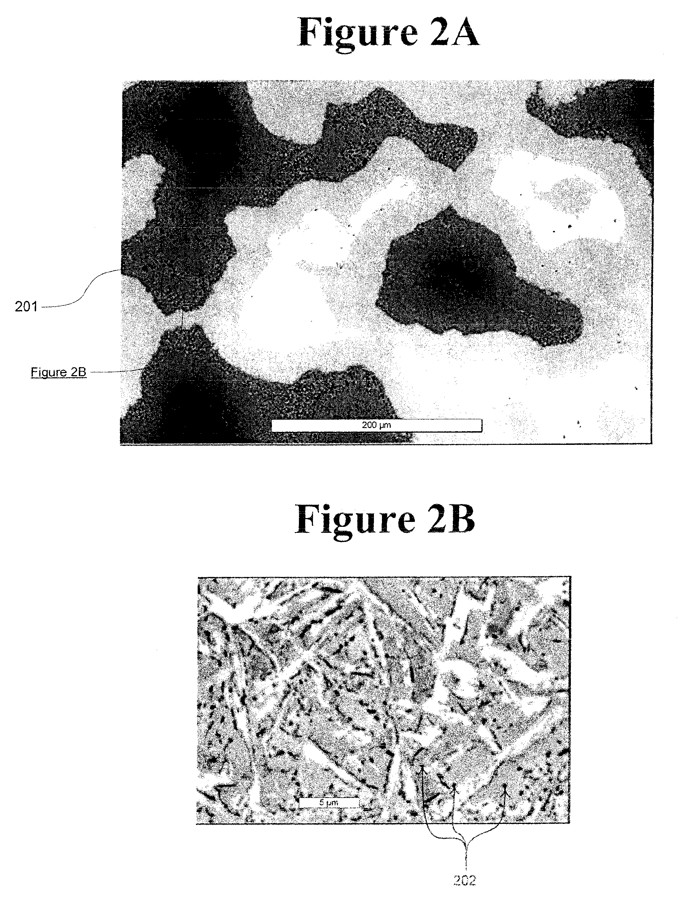

For example, Figures 1A and 1B are micrographs illustrating the segregation of cobalt and tungsten elemental phases in a sputter target manufactured using one approach. As can be seen with reference to Figure 1A (and to the closer view provided by Figure 1B), the lighter-colored tungsten elemental phases 101 are in many places separated by broad regions of cobalt elemental phases 102, rendering the sputtering target chemically inhomogeneous, and accordingly unsuitable for sputtering homogeneous cobalt-tungsten films. Figures 2A and 2B are micrographs illustrating the extensive micro-porosities in a sputter target manufactured using this approach. As can be seen with reference to Figure 2A (and to the closer view provided by Figure 2B), the cobalt-tungsten intermetallic phase 201 is riddled with Kirkendall porosities 202. These micro-porosities prevent the sputter target from being fully densified, and can negatively impact sputtering performance.

Turning to Figure 3A, the micro-cracking which significantly reduced the yield of one cobalt-tungsten sputter target manufacturing method can clearly be seen. For example, intermetallic region 301 has several large (*e.g.,* greater than 150 microns) cracks 302 present, several of which have propagated so far as to form a network of cracks, into which moisture may soak, allowing oxides and/or hydroxides to form and promote corrosion. Moreover, the sputter target of Figure 3A exhibits extensive micro-porosities 303, which prevent the sputter target from being fully densified (*e.g*., to greater than 99% of a theoretical maximum density of the composition thereof). Figure 3B likewise illustrates a drawback of some cobalt-tungsten sputter targets in which the tungsten elemental phase 304 has failed to completely sinter, leaving voids 305 into to which moisture may similarly soak, and which similarly prevent the sputter target form being fully densified.

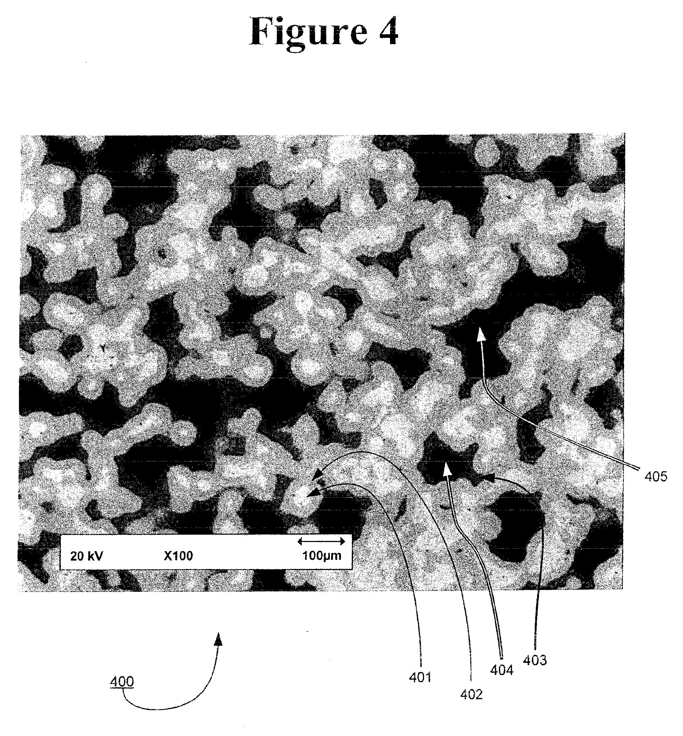

In accordance with one embodiment of the present invention, a cobalt-tungsten sputter target is provided which overcomes the foregoing problems. Figure 4 is a micrograph illustrating the microstructure of such a target according to one embodiment of the present invention. Sputter target 400 includes 60 atomic percent ("at.%") cobalt and 40 at.% tungsten (*i.e.,* sputter target 400 is a 60Co-40W target). As can be seen with reference to Figure 4, the cobalt and tungsten of sputter target 400 are present in both elemental and intermetallic phases. Specifically, sputter target 400 includes elemental tungsten phases (the brightest regions in this monochromatic micrograph) such as elemental tungsten phase 401, W-Co intermetallic phases, in which the atomic percentage of tungsten exceeds the atomic percentage of cobalt, such as W-Co intermetallic phase 402, Co-W intermetallic phases, in which the atomic percentage of cobalt exceeds the atomic percentage of tungsten, such as Co-W intermetallic phase 403, and elemental cobalt phases (the darkest regions in the micrograph) such as elemental cobalt phase 404.

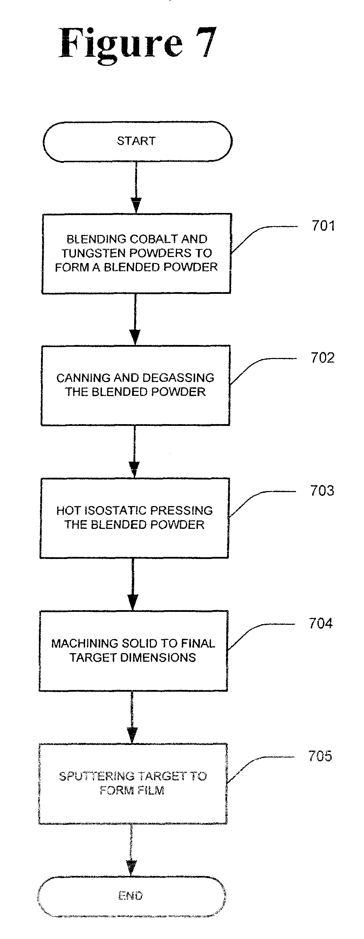

For the purposes of this application, an "elemental phase" may be understood to be a region of the sputter target which retains its elemental character (*i.e.,* is not an alloy), and which is a physical structure associated with one or more elemental particles that have been sintered by the fabrication process described in greater detail below with respect to Figure 7. Nevertheless, when multiple elemental particles have sintered together to form a contiguous structure, the term "elemental phase" may also be understood to encompass that larger structure. For example, the large dark region of elemental cobalt labeled 405 in Figure 4 may be considered a single elemental phase (as it is a contiguous structure retaining its elemental character), or alternatively this region 405 may be considered a number of contiguous elemental phases, each corresponding to a single elemental cobalt particle. Accordingly, the exemplary dimensions given below with respect to the elemental phases of cobalt and tungsten are property understood to apply to either elemental phases that correspond to single elemental particles sintered during fabrication, or contiguous elemental regions that correspond to multiple elemental particles sintered during fabrication.

As can be seen with reference to the scale in Figure 4, the tungsten and cobalt elemental phases (such as phases 401 and 404, respectively) are between 10 and 150 microns in width (*e.g.*, a dimension of these phases in cross section are between 10 and 150 microns). More particularly, in various embodiments, these elemental phases may be between 10 and 50 microns, between 50 and 100 microns, or between 100 and 150 microns. Similarly, the Co-W and W-Co intermetallic phases such as phases 402 and 403 may form layers which encapsulate or surround the elemental phases. These layers are between 10 and 100 microns in width (*e.g.*, a dimension of these phases in cross section is between 10 and 100 microns). More specifically, in this 60Co-40W sputter target 400 according to the present exemplary embodiment, many of the Co-W intermetallic phases form a layer (*e.g.*, between about 20 and 100 microns thick) around an elemental cobalt phase. Similarly, many of the W-Co intermetallic phases form a layer (*e.g.*, between about 10 and 80 microns thick) around an elemental tungsten phase.

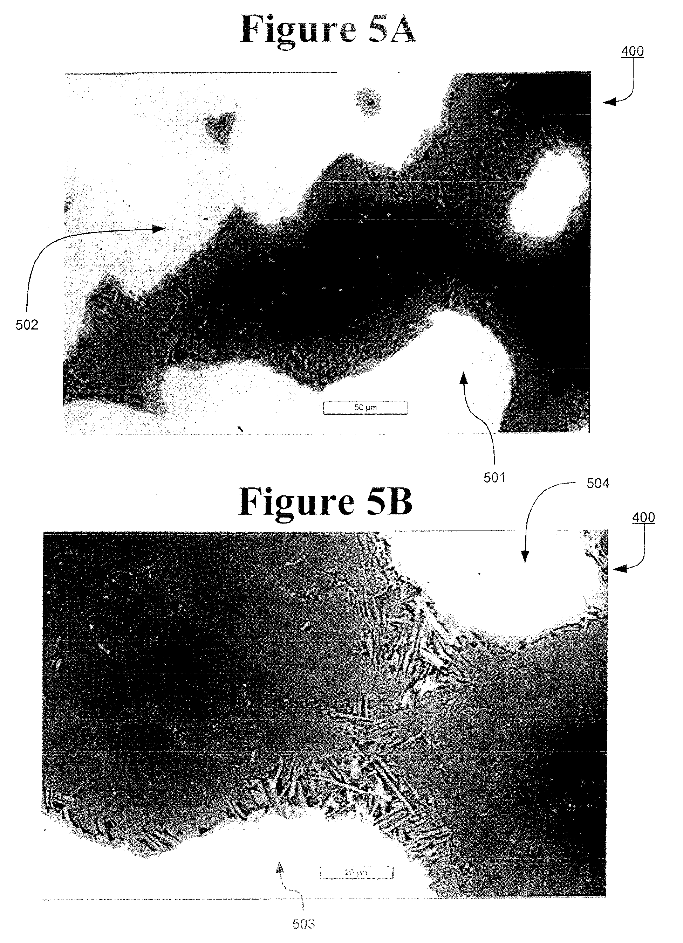

As will become evident when comparing Figure 4 with Figures 1A and 1B, the segregation of phases which plague other cobalt-tungsten sputter targets has been overcome in a sputter target manufactured in accordance with one embodiment of the present invention. Rather, the microstructure of sputter target 400 is substantially uniform, both across its width and through its thickness (*i.e.,* in the sputter direction). Additionally, as the volume fraction of the intermetallic phases has been optimized (*e.g.*, the intermetallic phases having a width of between 10 and 100 microns), the target enjoys a level of machinability and mechanical strength (*e.g*., resistance to cracking) that permits it to be shaped to any desired final shape (*e.g*., cylindrical, round, rectilinear, etc.) using any one of a number of machining techniques known to those of skill in the art. As will be seen with reference to Figures 5A and 5B below, sputter target 400 enjoys a number of additional benefits when compared to other cobalt-tungsten sputter targets

Figure 5A is a micrograph providing a more highly magnified view of sputter target 400. As can be seen with reference to Figure 5A, W-Co intermetallic regions 501 and 502 are substantially free of the large micro-cracks that were visible in the sputter target of Figure 3A. For example, the cross section of sputter target 400 illustrated in Figure 5A has, on average, fewer than 20 cracks per square millimeter, and those few cracks having an average length of less than 150 microns. Similarly, other cross sections of sputter target 400 will also have fewer than 20 cracks per square millimeter, with those few cracks having an average length of less than 150 microns. According to one embodiment of the present invention, a sputter target may have fewer than 20 cracks per square millimeter in any cross sectional portion of the target or in any entire cross section throughout the target, with those cracks having an average length of less than 150 microns.

Furthermore, as can be seen with reference to Figure 5B, sputter target 400 has substantially no voids in the elemental tungsten regions thereof. For example, in the cross section illustrated in Figure 5B, elemental tungsten regions 503 and 504 have, on average, fewer than less than 10 voids per square millimeter, with those few voids having an average size of less than 5 microns. Similarly, other cross sections of sputter target 400 will also have fewer than 10 voids per square millimeter, with those few voids having an average size of less than 5 microns. According to one embodiment of the present invention, a sputter target may have fewer than 10 voids per square millimeter in any cross sectional portion of the target or in any entire cross section throughout the target, with those voids having an average size of less than 5 microns. As a result of this substantially void- and crack-free microstructure, sputter target 400 has a density greater than 99% of a theoretical maximum density of a 60Co-40W alloy. This fully densified microstructure helps to prevent sputter target 400 from experiencing the oxidization and corrosion which plagues other sputter targets. Finally, sputter target 400 is substantially free of the Kirkendall porosities that were so prominently visible in the sputter target of Figures 2A and 2B.

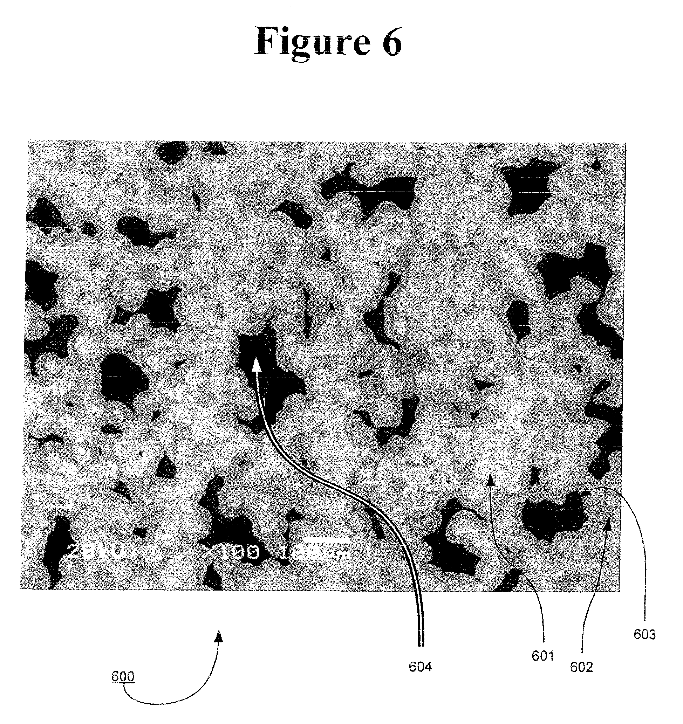

Turning to Figure 6, a sputter target according to another embodiment of the present invention is illustrated. Sputter target 600 includes 40 atomic percent ("at.%) cobalt and 60 at.% tungsten (*i.e.,* sputter target 600 is a 40Co-60W target). As can be seen with reference to Figure 6, the cobalt and tungsten of sputter target 600 is present in both elemental and intermetallic phases. Specifically, sputter target 600 includes elemental tungsten phases (the brightest regions in this monochromatic micrograph) such as elemental tungsten phase 601, W-Co intermetallic phases in which the atomic percentage of tungsten exceeds the atomic percentage of cobalt, such as W-Co intermetallic phase 602, Co-W intermetallic phases in which the atomic percentage of cobalt exceeds the atomic percentage of tungsten, such as Co-W intermetallic phase 603, and elemental cobalt phases (the darkest regions in the micrograph), such as elemental cobalt phase 604.

As can be seen with reference to the scale in Figure 6, the tungsten and cobalt elemental phases such as phases 601 and 604 are between 5 and 150 microns in width (*e.g.,* a dimension of these phases in cross section are between 5 and 150 microns). According to various other embodiments of the present invention, a sputter target may have elemental phases with cross-sectional dimension of between about 10 and 100 microns, between about 10 and 50 microns, between about 50 and 100 microns, or between about 100 and 150 microns.

Similarly, the Co-W and W-Co intermetallic phases such as phases 602 and 603 are between 10 and 100 microns in width (*e.g.*, a dimension of these phases in cross section are between 10 and 100 microns). More specifically, in this 40Co-60W sputter target 600, many of the Co-W intermetallic phases form a layer (between about 20 and 80 microns thick) around an elemental cobalt phase. Similarly, many of the W-Co intermetallic phases form a layer (between about 20 and 60 microns thick) around an elemental tungsten phase. According to various other embodiments of the present invention, a sputter target may have intermetallic phases with a thickness of between about 20 and 50 microns, between about 50 and 100 microns, between about 40 and 80 microns, or between about 10 and 90 microns.

While the foregoing exemplary embodiments have been described as "cobalt-tungsten" sputter targets, this label is not intended to imply a greater atomic percentage of cobalt than tungsten. Rather, the term "cobalt-tungsten" as used herein encompasses all compositions including both cobalt and tungsten, with any relative percentages, including compositions in which the amount of tungsten is greater than the amount of cobalt.

White the foregoing exemplary embodiments have been described as having two elemental phases and two intermetallic phases, the scope of the present invention is not limited to such an arrangement. Rather, in embodiments of the present invention in which a sputter target has a sufficiently low atomic percentage of either cobalt or tungsten, there may be no elemental phases of the scarcer element in the spuiter target. Accordingly, in various embodiments of the present invention, a sputter target may have either four phases (*i.e*, elemental Co, intermetallic Co-W, intermetallic W-Co and elemental W) or only three phases (*i.e.*, intermetallic Co-W, intermetallic W-Co and either elemental Co or elemental W).

Turning to Figure 7, a flowchart illustrating a method of manufacturing a sputter target according to one embodiment of the present invention is illustrated. The method begins with step 701, in which cobalt and tungsten powders are blended to form a blended powder. According to one aspect of the present invention, both the cobalt powder and the tungsten powder have substantially equal powder size distributions (*i.e.,* distributions or ranges of powder particle sizes). For example, sputter target 400 illustrated in Figures 4 to 5B was manufactured from cobalt and tungsten powders each having a particle size distribution ("PSD") between about +325 mesh and about -100 mesh (*i.e*., between about 44 and about 149 microns). Matching the PSD of the constituent powders prevents the undesirable segregation illustrated in Figures 1A and 1B from occurring. In addition to ensuring that the PSD of each powder matches that of the other, careful selection of the PSD for both powders can provide a uniform microstructure and prevent excessive intermetallic formation. For example, choosing a PSD which includes excessively small (*e.g.*, < +625 mesh or < 20 microns) particles provides too much surface area between the cobalt and tungsten elements, resulting in excessive intermetallic phase formation and the concomitant loss of machinability. Choosing a PSD which includes excessively large (*e.g.*, > -60 mesh or > 250 microns) particles will allow non-uniform microstructures to develop, reducing the uniformity and chemical homogeneity of films sputtered from the targets. Thus, in accordance with one embodiment of the present invention, particle size distributions between about +625 mesh and about -60 mesh (*i.e.,* between about 20 and about 250 microns) are blended in step 701.

In accordance with one embodiment of the present invention, a tumbler-type blender is used, for a time between 10 and 120 minutes. For example, the constituent powders of sputter target 400 illustrated in Figures 4 to 5B were blended in a tumbler-type blender for about 45 minutes.

The method continues in step 702, in which the blended powder from step 701 is canned and degassed. For example, the blended powder may be loaded into a steel cylinder and subjected to near-vacuum conditions to extract any atmospheric (or other) gases from the blended powder prior to heating to ensure that the final sputter target will be fully densified.

In step 703, the degassed blended powder is hot pressed (*e.g.,* by hot isostatic pressing). The hot isostatic pressing ("HIPing") includes heating to a first soak temperature between about 500 °C and about 1050 °C, and holding at that temperature for between about 15 and 120 minutes. Then, the HIPing continues by heating to a second soak temperature between about 1050 °C and 1450 °C and pressurizing to a pressure between about 15 kilopounds per square inch ("ksi") and about 45 ksi. This pressure and temperature is held for between about 20 and 360 minutes. Then the target is cooled at a controlled rate and unloaded from the can. Of course, additional soak times and temperatures may be used in addition to those disclosed herein.

For example, sputter target 400 illustrated in Figures 4 to 5B was HIPed using a three-stage process. First, the degassed blended powders were heated to about 800 °C and held at that temperature for about 60 minutes. Next, they were heated to about 1050 °C, pressurized to about 29 ksi, and held at that temperature and pressure for about 240 minutes. Then, they were heated to about 1236 °C, kept pressurized at about 29 ksi, and held at that temperature and pressure for about 60 minutes. Following these three soaks, the controlled cooling took place from about 1236 °C to about 800 °C at a rate of about 2 °C/minute. The temperature of about 800 °C was held for about 60 min, and then controlled cooling continued from about 800 °C to about 400 °C at a rate of about 3 °C/minute. Once a temperature of about 400 °C was reached, the heating mechanism was powered off, and the dense solid was removed from the can after cooling to below 300 °C.

In step 704, the dense solid formed in step 703 is machined to the desired final dimensions. Because of the careful selection of the PSD of the powders in step 701, the dense solid does net contain excessive intermetallic phases, and accordingly is not as prone to cracking during machining as other cobalt-tungsten sputter targets. This permits the dense solid to be machined to any desired shape (*e.g.,* cylindrical, round, rectilinear, *etc.*).

In step 705, the sputter target is sputtered in a process well known to those of skill in the art. Because of the foregoing advantages enjoyed by the sputter targets of the various embodiments of the present invention, the uniformity and yield of a cobalt-tungsten film sputtered therefrom is greatly improved over other cobalt-tungsten sputter targets.

While the present invention has been particularly described with reference to the various figures and embodiments, it should be understood that these are for illustration purposes only and should not be taken as limiting the scope of the invention. There may be many other ways to implement the invention. Many changes and modifications may be made to the invention, by one having ordinary skill in the art, without departing from the spirit and scope of the invention.

## Claims

1. A method of fabricating a sputter target, the method comprising the steps of:
selecting a cobalt powder having a particle size distribution and a tungsten powder having the same particle size distribution;
blending the cobalt powder and the tungsten powder to form a blended powder; canning the blended powder;
hot pressing the blended powder to form a solid; and
machining the solid to form a sputter target.

2. The method according to claim 1, wherein the solid has a density greater than 99% of a theoretical maximum density thereof.

3. The method according to claim 1, wherein the particle size distribution is between about 20 and 250 microns.

4. The method according to claim 1, wherein the particle size distribution is between about 40 and 150 microns.

5. The method according to claim 1, wherein the hot pressing is hot isostatic pressing which includes:
heating to a first soak temperature between about 500°C and 1050 °C,
holding at the first soak temperature for between about 15 and 120 minutes,
heating to a second soak temperature between about 1050 °C and 1450 °C and pressurizing to a pressure between about 15 ksi and about 45 ksi, and
holding, at the second soak temperature and at the pressure between about 15 ksi and about 45 ksi for between about 20 to 360 minutes.

6. The method according to claim 1, wherein the hot pressing is hot isostatic pressing which includes:
heating to about 800 °C and holding at about 800 °C for about 60 minutes,
heating to about 1050 °C, pressurizing to about 29 ksi and holding at about 1050 °C and about 29 ksi for about 240 minutes, and
heating to about 1236 °C, maintaining a pressure of about 29 ksi and holding at about 1236 °C and about 29 ksi for about 60 minutes.

7. The method according to claim 6, wherein the hot isostatic pressing further includes:
cooling from about 1236 °C to about 800 °C at a rate of about 2 °C/minute,
holding at about 800 °C for about 60 min, and
cooling from about 800 °C to about 400 °C at a rate of about 3 °C/minute.

8. The method according to claim 1, wherein the cobalt powder is a powder of elemental cobalt.

9. The method according to claim 1, wherein the tungsten powder is a powder of elemental tungsten.

10. The method according to claim 1, further comprising the step of sputtering the sputter target to form a film including cobalt and tungsten.

11. A film sputtered according to the method of claim 10.

12. A cobalt-tungsten sputter target, comprising:
a first elemental phase of a first material, the first material being either cobalt or tungsten;
a first intermetallic phase including the first material and a second material, the second material being either tungsten or cobalt and different from the first material, the first material in a greater atomic percentage than the second material; and
a second intermetallic phase including the second material and the first material, the second material in a greater atomic percentage than the first material,
wherein the sputter target includes 20-80 at.% cobalt, and
wherein a density of the sputter target is greater than 99% of a theoretical maximum density thereof.

13. The sputter target of claim 12, wherein the first intermetallic phase is a layer surrounding the first elemental phase.

14. The sputter target of claim 12, further comprising a second elemental phase of the second material.

15. The sputter target of claim 14, wherein the second intermetallic phase is a layer surrounding the second elemental phase.

16. The sputter target of claim 14, wherein the second elemental phase has a cross-sectional dimension of between about 5 microns and about 150 microns.

17. The sputter target of claim 12, wherein the first elemental phase has a cross-sectional dimension of between about 5 microns and about 150 microns.

18. The sputter target of claim 12, wherein each of the first intermetallic phase and the second intermetallic phase has a thickness of between about 10 microns and about 100 microns.

19. The sputter target of claim 12, wherein the sputter target includes 40-60 at.% cobalt.

20. The sputter target of claim 12, wherein a cross section of the sputter target includes an average of less than 10 voids per square millimeter.

21. The sputter target of claim 20, wherein the voids have an average size of less than 5 microns.

22. The sputter target of claim 12, wherein a cross section of the sputter target includes an average of less than 20 cracks per square millimeter.

23. The sputter target of claim 22, wherein the cracks have an average length of less than 150 microns.
